# FASCICULE DE BREVET EUROPEEN

(11) **EP 0 451 089 B1**
(45) Date de publication et mention de la délivrance du brevet: **03.05.1995**
(21) Numéro de dépôt: 91810138.7
(22) Date de dépôt: 01.03.1991
(51) Int. Cl.: H03H 9/19, H03H 9/05

(54) **Résonateur piézoélectrique à haute fréquence**
Hochfrequenter piezoelektrischer Schwinger
High frequency piezoelectric resonator

(30) Priorité: 08.03.1990 CH 738/90
(43) Date de publication de la demande: 09.10.1991
(73) Titulaire: CENTRE SUISSE D'ELECTRONIQUE ET DE MICROTECHNIQUE S.A., 2007 Neuchâtel (CH)
(72) Inventeur: Hermann, Jean, CH-2000 Neuchâtel (CH)
(74) Mandataire: Brulliard, Joel

(56) Documents cités:
- EP-A- 0 096 653
- EP-A- 0 350 443
- PROCEEDINGS OF THE 39TH ANNUAL FREQUENCY SYMPOSIUM, Philadelphia, PA, 29-31 mai1985, pages 375-380, IEEE, New York, US; J.W. HERMANN: "A novel miniature ZT-cut resonator"
- PATENT ABSTRACTS OF JAPAN, vol. 6, no. 32 (E-96)[910], 26 février 1982;& JP-A-56 152 313 (CITIZEN) 25-11-1981

## Description

La présente invention concerne un résonateur piézoélectrique à haute fréquence, vibrant selon un mode de contour, présentant une courbe caractéristique de variation de la fréquence en fonction de la température, de type cubique et capable d'être réalisé par attaque chimique d'un substrat de quartz.

Un résonateur à mode de contour se présente sous la forme d'une plaque mince à mouvements dans le plan. L'épaisseur doit être suffisamment faible pour que les forces d'inertie provoquées par les mouvements hors du plan, aient une influence négligeable sur l'énergie de déformation. La forme la plus couramment adoptée est le rectangle, ce qui implique l'existence de quatre paramètres géométriques:
- un ou deux angles de coupe pour définir la direction de la normale à la plaque;
- un angle de coupe pour définir l'orientation des côtés du rectangle dans le plan de la plaque, et
- les dimensions du rectangle.

Un résonateur connu, présentant de bonnes propriétés thermiques et une quasi-indépendance du coefficient thermique de premier ordre au rapport dimensionnel w/l, est le résonateur à quartz de coupe ZT décrit dans le brevet français No 2 435 855. La coupe décrite dans ce brevet sera appelée par la suite coupe ZTY. Un tel résonateur, dont la forme de base est un rectangle, peut également présenter une structure plus complexe par combinaison de plusieurs rectangles de base qui, du point de vue de la propagation des ondes élastiques, peuvent être considérés comme des rectangles pseudo-libres. Des exemples de telles combinaisons peuvent être trouvés dans le brevet précité, de même que dans le brevet français No 2 521 782 et décrivant des structures de résonateur encastrable de coupe dite ZTY.

Les résonateurs de coupe ZTY sont obtenus à partir d'un cristal de quartz de coupe Z (c'est-à-dire un cristal de quartz ayant l'axe optique Z pour normale), par une première rotation autour de l'axe mécanique Y du cristal, suivie d'une deuxième rotation autour de la normale au plan du résonateur.

Un résonateur à quartz de coupe ZTX est décrit dans la demande de brevet français No 88 09221. Un tel résonateur est réalisé dans une plaque de quartz mince et rectangulaire dont la largeur est dirigée selon l'axe électrique X du cristal, la longueur est dirigée selon un axe Y′ et l'épaisseur est dirigée selon un axe Z′; les axes Y′ et Z′ formant avec, respectivement, les axes mécanique Y et optique Z du cristal, un angle ρ égal approximativement à 24°24′ et dont le rapport w/l de la largeur à la longueur est sensiblement égal à 0.64. Lorsqu'un tel résonateur est obtenu par attaque chimique d'une telle plaque, il est aisé de voir que les faces latérales parallèles à l'axe Y′ sont dans le plan d'attaque privilégié (direction de l'axe Z) et seront, de ce fait, exactement perpendiculaires aux grandes surfaces du résonateur.

Les résonateurs à quartz de coupe ZTX ou ZTY permettent un fonctionnement dans une gamme de fréquences en dessous de environ 4 MHz. Un résonateur fonctionnant dans une gamme de fréquences plus élevée peut être obtenu par réduction de l'ensemble des dimensions de la structure de base du résonateur. Un tel résonateur nécessiterait alors une épaisseur de plaque t d'une valeur d'environ 30 »m, valeur très inférieure à la valeur utilisable en pratique, qui est située autour de 100 »m.

La solution consistant à réduire la largeur w et la longueur l de la structure de base du résonateur, tout en maintenant l'épaisseur de plaque à une valeur acceptable, a pour inconvénient majeur d'augmenter notablement l'impédance du résonateur.

La présente invention se propose de réaliser un résonateur à quartz de coupe ZTX ou ZTY disposant des mêmes propriétés et fonctionnant dans une gamme de fréquences plus élevées.

Un autre objet de l'invention est un résonateur dont la suspension assure un bon couplage élastique entre les deux plaques.

Un autre objet de l'invention est un résonateur dont la zone de suspension permet une fixation de la structure dudit résonateur hors de son centre.

Un autre objet de l'invention est un résonateur comportant une pluralité de rectangles de base, agencés de manière à permettre sa fixation à un boîtier, par encastrement.

D'autres objets, caractéristiques et avantages de la présente invention apparaîtront plus clairement à la lecture suivante d'exemples d'application particuliers, ladite description étant faite à titre d'exemple non limitatif et en relation avec les dessins joints dans lesquels:
- les figures 1.a et 1.b: montrent l'orientation, par rapport au axes cristallographiques X ,Y, Z du quartz, d'un élément de base utilisé dans la structure selon l'invention, dans les cas d'un cristal de coupe ZTY et ZTX respectivement;
- la fig. 2: est une vue en perspective du résonateur simple utilisant l'élément de base de la figure 1 et montrant l'emplacement des électrodes;
- la fig. 3: montre un résonateur obtenu par la combinaison de trois éléments de base juxtaposés et
- la fig. 4: montre un exemple de résonateur selon l'invention de forme plus complexe et permettant sa fixation à un boîtier par encastrement.

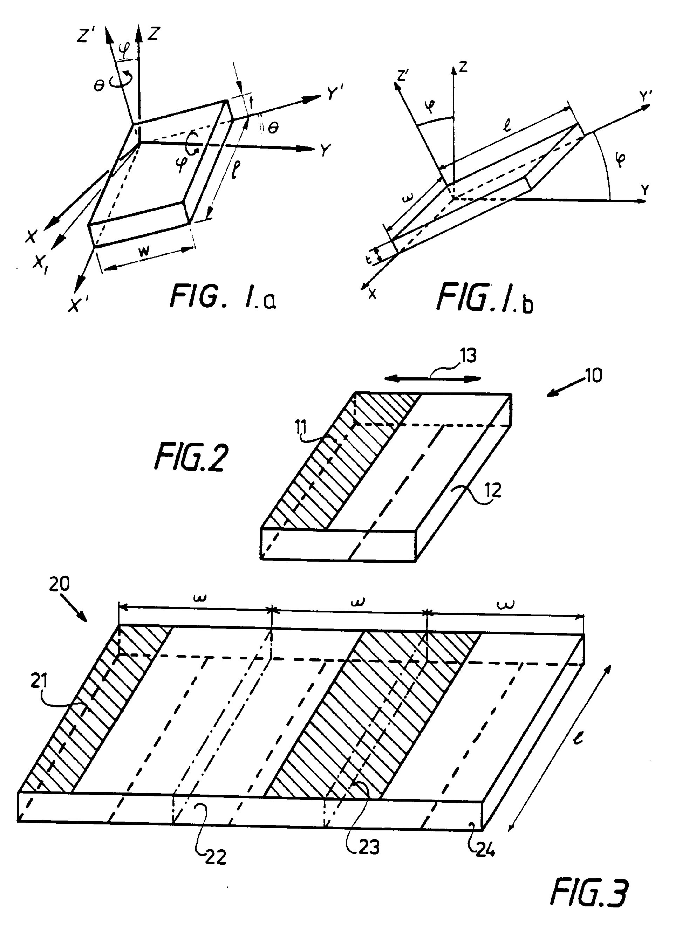

En référence à la figure 1.a, la plaque appelée plaque de coupe ZTY, coupe décrite dans le brevet français No 2 435 855, s'obtient de préférence à partir d'un cristal de quartz de coupe Z, c'est à dire un cristal ayant pour normale son axe optique Z. Une première rotation d'angle ρ autour de l'axe mécanique Y amène l'axe optique Z en Z′ et l'axe électrique X en X₁. Une seconde rotation d'angle ϑ autour de l'axe Z amène les axes X₁ en X′ et Y en Y′. Les directions principales X′, Y′, Z′ correspondent, respectivement, à la longueur l, la largeur w et l'épaisseur t de la plaque de coupe ZT. Selon les normes IRE, "Standards on piezoelectric crystals, 1949˝ publiées dans proceedings of the I.R.E., Vol. 37, No 12, Décembre 1949, une telle coupe est notée (z x w t) ρ, ϑ. Pour remplir les conditions énoncées précédemment, il convient de choisir les angles ρ et ϑ tels que 16° < ρ < 36°, 10° < ϑ < 26° et le rapport dimensionnel w/l tel que w/l soit compris entre 0.5 et 0.8. Les meilleurs résultats sont obtenus pour ρ approximativement égal à 26°, ϑ approximativement égal à 20° et w/l approximativement égal à 2/3.

En référence à la figure 1.b, la plaque appelée plaque de coupe ZTX, coupe décrite dans la demande de brevet français No 88 09221, s'obtient de préférence à partir d'un cristal de quartz de coupe ZY, l'axe mécanique Y indiquant la direction de la longueur de la plaque. Une rotation d'angle ρ autour de l'axe électrique X amène l'axe Y en Y′ et l'axe Z en Z′. Les directions principales X,Y′ et Z′ correspondent respectivement à la largeur w, la longueur l et l'épaisseur t de la plaque de coupe ZTX. Selon les normes IRE (1949), une telle coupe est notée (Z Y W)ρ. Le résonateur de l'invention est alors parfaitement défini lorsque sont précisées les valeurs de l'angle ρ et du rapport dimensionnel de la largeur w à la longueur l du résonateur. Les meilleurs résultats sont obtenus lorsque l'angle ρ est approximativement égal à 24°24′ et le rapport dimensionnel w/l est approximativement égal à 0.64. On constate que la courbe caractéristique de variation de la fréquence en fonction de la température est une courbe cubique, dont le point d'inflexion (coefficient thermique de deuxième ordre) peut être adapté par un choix approprié du rapport dimensionnel. La valeur du coefficient thermique de premier ordre α, qui représente la pente de la courbe caractéristique au point d'inflexion, dépend de l'angle de coupe ρ. Il peut être annulé ou ajusté à une valeur proche de zéro selon la grandeur de la plage de température dans laquelle le résonateur doit présenter de bonnes propriétés thermiques. Outre l'ajustement requis de l'angle de coupe ρ et du rapport dimensionnel w/l pour une adaptation aux conditions de fonctionnement choisies ( température typique de fonctionnement et plage de température), il est également nécessaire de compenser certains effets perturbateurs qui ne peuvent être modélisés. Il y a lieu de tenir compte, en particulier, de l'effet de la métallisation (effets électrique, élastique et massique des électrodes), de la suspension du résonateur (soudure des fils de suspension ou bras de suspension et zones d'encastrement), de la valeur non nulle de l'épaisseur du résonateur, des tolérances de fabrication (obliquité de certaines faces due au procédé d'attaque chimique), etc. On comprend, dès lors, que les valeurs indiquées ci-dessus d'angle de coupe et de rapport dimensionnel sont des valeurs typiques dont on peut s'écarter, de 1 à 3° pour ρ et 1 à 5% pour w/l, afin d'optimiser le résonateur en fonction de l'application choisie. La largeur w et la longueur l seront choisies en fonction de la fréquence de fonctionnement. La fréquence par unité de largeur est sensiblement égale à 2718 kHz.mm. L'épaisseur t est, comme dans tous les résonateurs à mode de contour, un paramètre relativement libre qui pourra être utilisé pour optimiser les performances du résonateur selon l'invention.

La figure 2 montre un exemple de résonateur muni d'électrodes. Les électrodes 11 et 12 sont obtenues par métallisation partielle des grandes faces du résonateur 10 et sont symétriques l'une de l'autre par rapport au centre du résonateur. La largeur des métallisations est déterminée en fonction de la capacité dynamique voulue. La polarisation des électrodes engendre un champ électrique diagonal permettant d'exciter un mode d'allongement selon la direction indiquée par la flèche 13.

La figure 3 montre une première variante de résonateur qui consiste en une plaque 20 qui peut être considérée comme la combinaison de trois résonateurs de base, dont la largeur w et la longueur l sont telles que le rapport w/l est sensiblement égal à 0.64. La configuration des électrodes 21, 22, 23 et 24 est également illustrée sur la figure.

Il convient de noter que la variante de la figure 3 ne constitue qu'un exemple de configuration possible, associant plusieurs structures de base et que, de manière générale, on peut combiner un nombre entier N de structures de base. Une telle combinaison est réalisée de manière que la direction du mouvement soit conservée, c'est à dire en juxtaposant lesdites structures de base par leur grand côté.

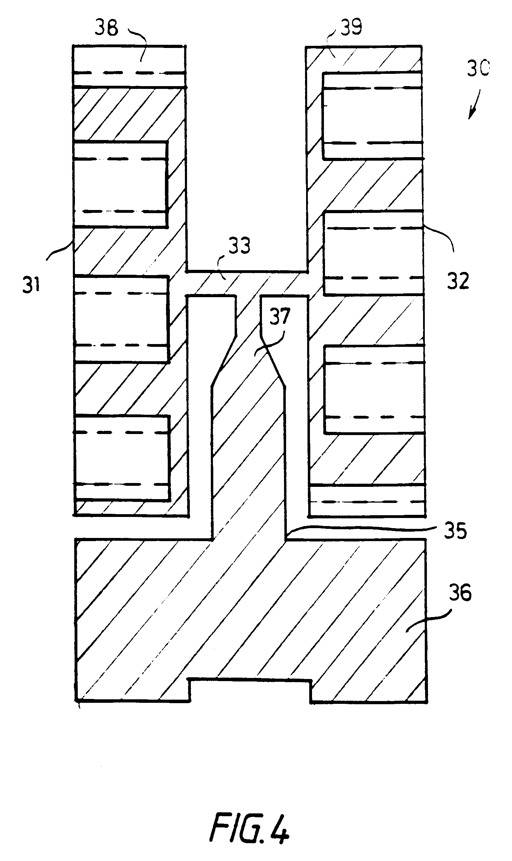

Alors que les variantes représentées dans les figures 1 à 3 peuvent être fixées à un boîtier par l'intermédiaire de fils de suspension, fixés par soudure, au centre des grandes faces des résonateurs, la variante de la figure 4 peut être fixée à un boîtier par l'intermédiaire d'un bras de suspension, solidaire du résonateur et comportant une zone d'encastrement et une zone de liaison.

La figure 4 montre un résonateur 30, qui comporte deux plaques rectangulaires 31 et 32, reliées par un bras 33. Ledit bras est relié à un bras de suspension 35, qui se compose successivement d'une zone d'encastrement 36 et d'une zone de liaison 37 pouvant, par exemple, être conique. Les métallisations des électrodes 38 et 39 sont représentées par une zone hachurée, pour une des faces, et par un contour en pointillé, pour l'autre face.

Dans un mode de réalisation préféré représenté à la figure 4, le résonateur comporte deux plaques rectangulaires constituées chacune de sept structures de base juxtaposées par leur grand côté. Le bras reliant les plaques est disposé au milieu desdites plaques et relie plus particulièrement deux structures de base. Dans le mode de réalisation préféré, lesdites deux structures de base opposées vibrent en contre-phase. Il est toutefois possible de répartir les métallisations des électrodes de manière que lesdites deux structures de base opposées vibrent en phase.

Conformément à l'invention, les deux plaques parallélépipèdiques rectangulaires sont disposées l'une à côté de l'autre dans un même plan. Les électrodes sont disposées et polarisées de manière à exciter préférentiellement l'un des harmoniques du mode de vibration de contour fondamental d'une structure de base. Ledit mode de contour est un mode d'allongement dans le sens de la largeur w. Les modes d'allongement de chacune des plaques parallélépipèdiques rectangulaires se produisent dans une direction perpendiculaire à l'axe du bras reliant lesdites plaques. Ledit bras reliant lesdites plaques est un bras non résonnant qui est relié à la zone d'encastrement par ladite zone de liaison, de manière à permettre la fixation de la structure du résonateur hors de son centre.

Bien que la présente invention ait été décrite dans le cadre d'exemples particuliers, il est clair cependant qu'elle n'est pas limitée à ces exemples et qu'elle est susceptible de modifications et de variantes sans sortir de son domaine. La possibilité, en particulier, de combiner des nombres pairs et/ou impairs de structures de base, par exemple, de manière que lesdites deux plaques se faisant face soient décalées l'une par rapport à l'autre, ledit bras reliant lesdites plaques étant positionné ou pas au milieu de l'une et/ou de l'autre plaque, laisse envisager une pluralité de variantes autre que celles décrites dans la description.

## Revendications

1. Résonateur piézoélectrique composé d'au moins une structure de base réalisée dans une plaque mince de quartz, ayant la forme d'un parallélépipède rectangle dont la largeur w est dirigée selon l'axe électrique X du cristal, la longueur l est dirigée selon un axe Y′ et l'épaisseur t est dirigée selon un axe Z′, lesdits axes Y′ et Z′ formant avec, respectivement, les axes mécanique Y et optique Z du crystal un angle ρ égal à 24°24′ ±3° et le rapport w/l de la largeur à la longueur est égal à N.(0.64 ±0.03), où N est un entier; comportant:
- deux plaques parallélépipèdiques rectangulaires (31,32) reliées entre elles par un bras (33) relié à une zone d'encastrement (36) et
- des électrodes (11,12; 21-24 et 38,39) disposées et polarisées de manière à exciter un mode de vibration de contour;
caractérisé en ce que:
- lesdites deux plaques parallélépipèdiques rectangulaires se composent, respectivement, de N et M structures de base, où N et M sont des entiers;
- lesdites deux plaques parallélépipèdiques rectangulaires sont disposées l'une à côté de l'autre dans un même plan et sont polarisées de manière que les modes d'allongement respectifs se produisent dans une direction perpendiculaire à l'axe du bras;
- ledit bras reliant lesdites deux plaques parallélépipèdiques rectangulaires est un bras non résonnant;
- lesdites électrodes sont disposées et polarisées de manière à exciter préférentiellement le N^{ème} harmonique dudit mode fondamental de vibration de contour de ladite structure de base et
- ledit bras est relié à une zone d'encastrement par une zone de liaison (37) de manière à permettre la fixation de la structure du résonateur hors de son centre.

2. Résonateur piézoélectrique composé d'au moins une structure de base réalisée dans une plaque mince de quartz, ayant la forme d'un parallélépipède rectangle dont la largeur w est orientée selon un axe Y′, la longueur l selon un axe X′ et l'épaisseur selon un axe Z′, et vibrant selon un mode de contour, l'axe Z′ normal aux grandes faces de la plaque étant situé dans le plan des axes électrique X et optique Z du cristal et formant avec l'axe Z un angle ρ tel que 16° < ρ < 36° et l'axe Y′ formant avec l'axe mécanique Y du cristal un angle Θ tel que 10° < Θ < 30°; comportant:
- deux plaques parallélépipèdiques rectangulaires (31,32) reliées entre elles par un bras (33) relié à une zone d'encastrement (36) et
- des électrodes (11,12; 21-24 et 38,39) disposées et polarisées de manière à exciter un mode de vibration de contour;
caractérisé en ce que:
- lesdites deux plaques parallélépipèdiques rectangulaires se composent, respectivement, de N et M structures de base, où N et M sont des entiers;
- lesdites deux plaques parallélépipèdiques rectangulaires sont disposées l'une à côté de l'autre dans un même plan et sont polarisées de manière que les modes d'allongement respectifs se produisent dans une direction perpendiculaire à l'axe du bras;
- ledit bras reliant lesdites deux plaques parallélépipèdiques rectangulaires est un bras non résonnant;
- lesdites électrodes sont disposées et polarisées de manière à exciter préférentiellement le N^{ème} harmonique dudit mode fondamental de vibration de contour de ladite structure de base et
- ledit bras est relié à une zone d'encastrement par une zone de liaison (37) de manière à permettre la fixation de la structure du résonateur hors de son centre.

3. Résonateur selon l'une quelconque des revendications 1 et 2, caractérisé en ce que N est égal à M.

4. Résonateur selon l'une quelconque des revendications 1 et 2, caractérisé en ce que N est différent de M.

## Patentansprüche

1. Piezoelektrischer Resonator, bestehend aus mindestens einer Basisstruktur, die in einer dünnen Quarzplatte realisiert ist mit der Form eines rechtwinkligen Parallelepipedes, dessen Breite w in Richtung der elektrischen Achse X des Kristalls gerichtet ist, dessen Länge l in Richtung einer Achse Y′ gerichtet ist und dessen Dicke t in Richtung einer Achse Z′ gerichtet ist, wobei die genannten Achsen Y′ und Z′ mit der mechanischen Achse Y bzw. optischen Achse Z des Kristalls einen Winkel ρ gleich 24°24′±3° bilden und das Verhältnis w/l der Breite zur Länge gleich N.(0,64±0,03) ist, wobei N eine ganze Zahl ist, umfassend:
- zwei rechtwinklige parallelepipedische Platten (31, 32), die über einen mit einer Befestigungszone (36) verbundenen Arm (33) miteinander verbunden sind und
- Elektroden (11,12; 21-24 und 38,39), die derart angeordnet und polarisiert sind, daß ein Konturvibrationsmodus erregt wird,
dadurch gekennzeichnet, daß
- die beiden parallelepipedischen rechtwinkligen Platten sich jeweils aus N bzw. M Basisstrukturen zusammensetzen, worin N und M ganze Zahlen sind;
- die rechtwinkligen parallelepipedischen beiden Platten nebeneinander in ein- und derselben Ebene angeordnet sind und derart polarisiert sind, daß die jeweiligen Verlängerungsmodus in einer Richtung senkrecht zur Achse des Arms erzeugt werden;
der die beiden rechtwinkligen parallelepipedischen Platten verbindende Arm ein nichtschwingender Arm ist;
- die Elektroden angeordnet und polarisiert sind derart, daß vorzugsweise die N-te Harmonische des Grundkonturvibrationsmodus der Basisstruktur erregt wird; und
- der Arm mit einer Befestigungszone über eine Verbindungszone (37) derart verbunden ist, daß die Befestigung der Struktur des Resonators außerhalb seines Zentrums ermöglicht wird.

2. Piezoelektrischer Resonator, bestehend aus mindestens einer Basisstruktur, realisiert in einer dünnen Quarzplatte mit der Form eines rechtwinkligen Parallelepipedes, dessen Breite w in Richtung einer Achse Y′ orientiert ist, dessen Länge l in Richtung einer Achse X′ orientiert ist und dessen Dicke in Richtung einer Achse Z′ orientiert ist und die in einem Konturmodus vibriert, wobei die Achse Z′ senkrecht zu den großen Flächen der Platte in der Ebene der elektrischen Achse X und der optischen Achse Z des Kristalls liegt und mit der Achse Z einen Winkel ρ derart bildet, daß 16°< ρ <36° beträgt und die Achse Y′ mit der mechanischen Achse Y des Kristalls einen Winkel ϑ derart bildet, daß 10°<ϑ<30°, umfassend:
- zwei rechtwinklige parallelepipedische Platten (31, 32), die über einen mit einer Befestigungszone (36) verbundenen Arm (33) miteinander verbunden sind und
- Elektroden (11,12; 21-24 und 38,39), die derart angeordnet und polarisiert sind, daß ein Konturvibrationsmodus erregt wird,
dadurch gekennzeichnet, daß
- die beiden parallelepipedischen rechtwinkligen Platten sich jeweils aus N bzw. M Basisstrukturen zusammensetzen, worin N und M ganze Zahlen sind;
- die rechtwinkligen parallelepipedischen beiden Platten nebeneinander in ein- und derselben Ebene angeordnet sind und derart polarisiert sind, daß die jeweiligen Verlängerungsmodus in einer Richtung senkrecht zur Achse des Arms erzeugt werden;
der die beiden rechtwinkligen parallelepipedischen Platten verbindende Arm ein nichtschwingender Arm ist;
- die Elektroden angeordnet und polarisiert sind derart, daß vorzugsweise die N-te Harmonische des Grundkonturvibrationsmodus der Basisstruktur erregt wird; und
- der Arm mit einer Befestigungszone über eine Verbindungszone (37) derart verbunden ist, daß die Befestigung der Struktur des Resonators außerhalb seines Zentrums ermöglicht wird.

3. Resonator nach einem der Ansprüche 1 und 2, dadurch gekennzeichnet, daß N gleich M ist.

4. Resonator nach einem der Ansprüche 1 und 2, dadurch gekennzeichnet, daß N unterschiedlich gegenüber M ist.

## Claims

1. Piezoelectric resonator composed of at least one base structure produced in a thin quartz plate, having the shape of a rectangular parallelepiped whose width w runs along the electrical axis X of the crystal, whose length l runs along an axis Y′ and whose thickness t runs along an axis Z′, the said axes Y′ and Z′ forming with, respectively, the mechanical Y and optical Z axes of the crystal an angle p equal to 24°24′ ± 3° and the ratio w/l of the width to the length is equal to N.(0.64 ± 0.03), where N is an integer; including:
- two rectangular parallelepipedal plates (31, 32) connected to each other by an arm (33) connected to an embedding area (36), and
- electrodes (11, 12; 21-24 and 38, 39), disposed and biased so as to excite a contour vibration mode;
characterised in that:
- the said two rectangular parallelepipedal plates are composed, respectively, of N and M base structures, where N and M are integers;
- the said two rectangular parallelepipedal plates are disposed one beside the other in the same plane and are biased so that the respective extension modes are established in a direction perpendicular to the axis of the arm;
- the said arm connecting the said two rectangular parallelepipedal plates is a non-resonant arm;
- the said electrodes are disposed and biased so as to excite preferentially the Nth harmonic of the said fundamental contour vibration mode of the said base structure, and
- the said arm is connected to an embedding area by a connecting area (37) so as to enable the structure of the resonator to be fixed away from its centre.

2. Piezoelectric resonator composed of at least one base structure produced in a thin quartz plate, having the shape of a rectangular parallelepiped whose width w is oriented along an axis Y′, whose length l is orientated along an axis X′ and whose thickness is oriented along an axis Z′, and vibrating according to a contour mode, the axis Z′ normal to the large faces of the plate being situated in the plane of the electrical X and optical Z axes of the crystal and forming with the axis Z an angle p such that 16° < ρ < 36° and the axis Y′ forming with the mechanical axis Y of the crystal an angle Θ such that 10° < Θ < 30°;
including:
- two rectangular parallelepipedal plates (31, 32) connected to each other by an arm (33) connected to an embedding area (36), and
- electrodes (11, 12; 21-24 and 38, 39), disposed and biased so as to excite a contour vibration mode;
characterised in that:
- the said two rectangular parallelepipedal plates are composed, respectively, of N and M base structures, where N and M are integers;
- the said two rectangular parallelepipedal plates are disposed one beside the other in the same plane and are biased so that the respective extension modes are established in a direction perpendicular to the axis of the arm;
- the said arm connecting the said two rectangular parallelepipedal plates is a non-resonant arm;
- the said electrodes are disposed and biased so as to excite preferentially the Nth harmonic of the said fundamental contour vibration mode of the said base structure, and
- the said arm is connected to an embedding area by a connecting area (37) so as to enable the structure of the resonator to be fixed away from its centre.

3. Resonator according to either one of Claims 1 and 2, characterised in that N is equal to M.

4. Resonator according to either one of Claims 1 and 2, characterised in that N is different from M.
